# EUROPEAN PATENT APPLICATION

(11) **EP 4 390 536 A2**
(43) Date of publication of application: **26.06.2024**
(21) Application number: 23215382.5
(22) Date of filing: 08.12.2023
(51) Int. Cl.: G03F 1/24

(54) **REFLECTIVE MASK BLANK, REFLECTIVE MASK, AND MANUFACTURING METHOD THEREOF**

(30) Priority: 21.12.2022 JP 2022204305
(71) Applicant: Shin-Etsu Chemical Co., Ltd., Tokyo (JP)
(72) Inventor: OGOSE, Taiga, Joetsu-shi (JP); KOSAKA, Takuro, Joetsu-shi (JP); INAZUKI, Yukio, Joetsu-shi (JP)
(74) Representative: Mewburn Ellis LLP

(57) **Abstract**

A reflective mask blank comprising a substrate, a multilayer reflection film that is formed on one main surface of the substrate and reflects exposure light, and a protection film that is formed on the multilayer reflection film, comprises ruthenium (Ru) and niobium (Nb), and includes a portion having a low ruthenium (Ru) content in the thickness direction compared with both ruthenium (Ru) contents at the side close to the multilayer reflection film and at the side remotest from the multilayer reflection film.

## Description

### TECHNICAL FIELD

The present invention relates to a reflective mask used in manufacturing semiconductor devices such as LSIs, a reflective mask blank which is a material for the reflective mask, and a method for manufacturing the reflective mask.

### BACKGROUND

In a manufacturing process of a semiconductor device, a photolithography technique in which a circuit pattern formed on a transfer mask is transferred onto a semiconductor substrate (a semiconductor wafer) through a reduction projection optical system with irradiating exposure light to the transfer mask is repeatedly used. Conventionally, a mainstream wavelength of the exposure light is 193 nm by argon fluoride (ArF) excimer laser light. A pattern with dimensions smaller than exposure wavelength has finally been formed by adopting a process called multi-patterning in which exposure processes and processing processes are combined multiple times.

However, since it is necessary to form a further fine pattern under continuous miniaturization of device patterns, an extreme ultraviolet lithography technique using, as exposure light, extreme ultraviolet (here after refers to as "EUV") light having a shorter wavelength than the wavelength of ArF excimer laser light has been used. The EUV light is light having a wavelength of about 0.2 to 100 nm, in particular, light having a wavelength of around 13.5 nm. The EUV light has a very low transparency to a substance and cannot be utilized for a conventional transmissive projection optical system or a mask, thus, a reflection type optical elemental device is applied. Therefore, a reflective mask is also proposed as a mask for the pattern transfer.

In the common reflective mask, a multilayer reflection film that reflects EUV light is formed on a substrate, and further an absorber film formed in a pattern that absorbs EUV light is formed on the multilayer reflection film. On the other hand, commonly, a material (including also a state in which a resist layer is formed) before patterning the absorber film is called a reflective mask blank, and is used as a material for the reflective mask.

The reflective mask blank has a basic structure including a low thermal expansion substrate, a multilayer reflection film that is formed thereon and reflects EUV light, and generally, further including an absorber film that is formed on the multilayer reflection film and absorbs EUV light. As the multilayer reflection film, a multilayer reflection film which is ensured a necessary reflectance for EUV light by alternately laminating molybdenum (Mo) films and silicon (Si) films are commonly used. Further, a ruthenium (Ru) film is formed on the multilayer reflection film as a protection film to protect the multilayer reflection film (Patent Document 1: JP-A 2002-122981). On the other hand, tantalum (Ta) which has a relatively large extinction coefficient with respect to EUV light is used for the absorber film (Patent Document 2: JP-A 2002-246299).

### Citation List

Patent Document 1: JP-A 2002-122981
Patent Document 2: JP-A 2002-246299

### SUMMARY OF THE INVENTION

The protection film has function for protecting the multilayer reflection film. However, in addition to function for preventing decrease of reflectance due to repeated EUV exposure to the reflective mask, it is required to have resistance to various dry etchings and cleaning with chemical solutions in a manufacturing process of the reflective mask.

In the manufacturing process of a reflective mask using a reflective mask blank as a material, when an absorber film is dry etched to form a pattern of an absorber film, a certain degree of over-etching is usually performed to control a pattern shape. By performing the over-etching, the protection film is exposed to etching, and is damaged.

In particular, for example, when the absorber film is composed of a material containing tantalum (Ta) and nitrogen (N), a gas containing chlorine and being free of oxygen is preferably used as an etching gas. Therefore, the protection film is required to have resistance to dry etching using a gas containing chlorine and being free of oxygen.

Further, when a hard mask pattern which is formed by patterning a hard mask film containing chromium (Cr) is used as an etching mask in forming a pattern to the absorber film, after forming the pattern of the absorber film, usually, the hard mask pattern is removed by dry etching using a gas containing chlorine and oxygen. The protection film is also exposed to the same dry etching at that time. Therefore, the protection film is also required to have resistance to dry etching using a gas containing chlorine and oxygen. Furthermore, to remove a resist in manufacturing the reflective mask and to remove contamination in repeated use of the reflective mask, the reflective mask is cleaned with a chemical solution using sulfuric acid-hydrogen peroxide mixture (SPM). Therefore, the protection film is also required to have resistance to SPM cleaning.

If the protection film is damaged, and changes in film quality and thickness are caused in etching in manufacturing the reflective mask or in cleaning in manufacturing or use of the reflective mask, problems such as loss of the function for protecting the multilayer reflection film are occurred in the protection film. A protection film composed of simple ruthenium (Ru) does not have sufficient resistance to dry etching using, particularly, a gas containing chlorine and oxygen. Therefore, the film thickness decreases in removing process of the hard mask pattern, a problem of deterioration in the function for protecting the multilayer reflection film is occurred in the protection film.
So, a protection film added with an additive element such as niobium (Nb) to the protection film containing ruthenium (Ru) has been proposed to enhance the function for protecting the multilayer reflection film by improving the resistance to etching. However, the additive element is a metal which has a lowly standard oxidation-reduction potential compared with ruthenium (Ru), and oxidation reaction on the surface of the protection film tends to proceed by adding the additive element into the protection film. As a result, a rate at which the thickness of the protection film decreases due to SPM cleaning increases, and the damage to the protection film in patterning the absorber film increases by increasing a thickness of a natural oxide layer formed on the surface portion of the protection film after forming the protection film.

As described above, the protection film is variously damaged by over-etching in patterning of the absorber film, removal of the hard mask pattern by etching, removal of the resist and the contamination with using SPM cleaning, and others. Accordingly, the function for protecting the multilayer reflection film in use of the reflective mask is deteriorated when the thickness of the protection film is decreased.

The present invention has been made to solve the above problems, and an object of the present invention is to provide a reflective mask blank and a reflective mask including a protection film that has high resistances to dry etching using a gas containing chlorine and being free of oxygen, to dry etching using a gas containing chlorine and oxygen, and to SPM cleaning, and a method for manufacturing the reflective mask.

The inventors have made earnestly studies to solve the above problems. As a result, the inventors found, with respect to a reflective mask blank and a reflective mask that include a protection film for a multilayer reflection film formed on one main surface of a substrate, a protection film that contains ruthenium (Ru) and niobium (Nb), and includes a portion having a low ruthenium (Ru) content in the thickness direction compared with both ruthenium (Ru) contents at the side close to the multilayer reflection film, and the side remotest from the multilayer reflection film. Further, the inventors found that the protection film has high resistances to dry etching using a gas containing chlorine and being free of oxygen, to dry etching using a gas containing chlorine and oxygen, and to SPM cleaning.

In one aspect, the invention provides a reflective mask blank including a substrate, a multilayer reflection film that is formed on one main surface of the substrate and reflects exposure light, and a protection film that is formed on the multilayer reflection film wherein
the protection film contains ruthenium (Ru) and niobium (Nb),
the protection film includes a portion having a low ruthenium (Ru) content in the thickness direction compared with both ruthenium (Ru) contents at the side close to the multilayer reflection film and at the side remotest from the multilayer reflection film.

Preferably, the portion having a low ruthenium (Ru) content in the protection film contains niobium (Nb), and the portion having a low ruthenium (Ru) content in the protection film has a ruthenium (Ru) content of not more than 85 at%.

Preferably, the ruthenium (Ru) content of the protection film at the side close to the multilayer reflection film is not less than 95 at%, and
the ruthenium (Ru) content of the protection film at the side remotest from the multilayer reflection film is not less than 90 at%.

Preferably, the reflective mask blank includes an absorber film that is formed on the protection film and absorbs the exposure light wherein
the absorber film contains tantalum (Ta) and nitrogen (N).

Preferably, the reflective mask blank further includes a hard mask film that contains chromium (Cr) on the absorber film.

Preferably, the protection film consists of a first layer, a second layer and a third layer in this order from the multilayer reflection film side,
the first layer contains ruthenium (Ru) and does not contain substantively any other elements except for ruthenium (Ru),
the second layer contains niobium (Nb), and
the third layer contains ruthenium (Ru) and does not contain substantively any other elements except for ruthenium (Ru).

Preferably, the second layer further contains ruthenium (Ru).

Preferably, the protection film has an average ruthenium (Ru) content in the whole of the protection film of not less than 50 at% and not more than 95 at%.

Preferably, the reflective mask blank includes an absorber film that is formed on the protection film and absorbs the exposure light wherein
the absorber film contains tantalum (Ta) and nitrogen (N).

Preferably, the reflective mask blank includes a hard mask film that contains chromium (Cr) on the absorber film.

In another aspect, the invention provides a reflective mask including a substrate, a multilayer reflection film that is formed on one main surface of the substrate and reflects exposure light, a protection film that is formed on the multilayer reflection film, and a pattern of an absorber film that is formed on the protection film and absorbs the exposure light wherein
the protection film contains ruthenium (Ru) and niobium (Nb),
the protection film includes a portion having a low ruthenium (Ru) content in the thickness direction compared with both ruthenium (Ru) contents at the side close to the multilayer reflection film and at the side remotest from the multilayer reflection film.

Preferably, the portion having a low ruthenium (Ru) content in the protection film contains niobium (Nb), and the portion having a low ruthenium (Ru) content in the protection film has a ruthenium (Ru) content of not more than 85 at%.

Preferably, the ruthenium (Ru) content of the protection film at the side close to the multilayer reflection film is not less than 95 at%, and
the ruthenium (Ru) content of the protection film at the side remotest from the multilayer reflection film is not less than 90 at%,

Preferably, the protection film consists of a first layer, a second layer and a third layer in this order from the multilayer reflection film side,
the first layer contains ruthenium (Ru) and does not contain substantively any other elements except for ruthenium (Ru),
the second layer contains niobium (Nb), and
the third layer contains ruthenium (Ru) and does not contain substantively any other elements except for ruthenium (Ru).

Preferably, the second layer further contains ruthenium (Ru).

Preferably, the protection film has an average ruthenium (Ru) content in the whole of the protection film of not less than 50 at% and not more than 95 at%.

In another aspect, the invention provides a method for manufacturing a reflective mask including the steps of
forming a pattern of a resist film on the absorber film of the reflective mask blank,
forming a pattern of the absorber film by dry etching using a gas containing chlorine and being free of oxygen with using the pattern of the resist film as an etching mask,
after the step of forming the pattern of the absorber film, removing the pattern of the resist film by SPM cleaning.

In the other aspect, the invention provides a method for manufacturing a reflective mask including the steps of
forming a pattern of a resist film on the hard mask film of the reflective mask blank,
forming a pattern of the hard mask film by dry etching using a gas containing chlorine and oxygen with using the pattern of the resist film as an etching mask,
forming a pattern of the absorber film by dry etching using a gas containing chlorine and being free of oxygen with using the pattern of the hard mask film as an etching mask,
after the step of forming the pattern of the absorber film, removing the pattern of the resist film by SPM cleaning,
after the step of removing the pattern of the resist film, removing the pattern of the hard mask film by dry etching using a gas containing chlorine and oxygen.

### ADVANTAGEOUS EFFECTS

The protection film of the reflective mask blank and the reflective mask of the invention has high resistances to dry etching using a gas containing chlorine and being free of oxygen, and to dry etching using a gas containing chlorine and oxygen in manufacturing the reflective mask. Further, the protection film has high resistance to SPM cleaning in manufacturing the reflective mask or use of the reflective mask. Accordingly, the damage to the protection film in the function for protecting the multilayer reflection film is small, and decrease of the reflectance of the multilayer reflection film is controlled.

### BRIEF DESCRIPTION OF THE DRAWINGS

FIG. 1 is a cross-sectional view illustrating an example of first embodiment of a reflective mask blank of the invention.
FIG. 2 is a cross-sectional view illustrating an example of second embodiment of a reflective mask blank of the invention.
FIGS. 3A and 3B are cross-sectional views illustrating examples of third embodiment of a reflective mask blank and a reflective mask of the invention, FIG. 3A being a cross-sectional view of the reflective mask blank, FIG. 3B being a cross-sectional view of the reflective mask.
FIGS. 4A and 4B are cross-sectional views illustrating examples of fourth embodiment of a reflective mask blank and a reflective mask of the invention, FIG. 4A being a cross-sectional view of the reflective mask blank, FIG. 4B being a cross-sectional view of the reflective mask.
FIGS. 5A and 5B are cross-sectional views illustrating examples of fifth embodiment of a reflective mask blank and a reflective mask of the invention, FIG. 5A being a cross-sectional view of the reflective mask blank, FIG. 5B being a cross-sectional view of the reflective mask.
FIGS. 6A and 6B are cross-sectional views illustrating examples of sixth embodiment of a reflective mask blank and a reflective mask of the invention, FIG. 6A being a cross-sectional view of the reflective mask blank, FIG. 6B being a cross-sectional view of the reflective mask.

### FURTHER EXPLANATIONS; OPTIONS AND PREFERENCES

A reflective mask blank of the invention includes a substrate, a multilayer reflection film that is formed on the substrate (on one main surface (front-side surface) of the substrate), and reflects exposure light, a protection film that is formed on the multilayer reflection film. The reflective mask blank is suitable for a material (an EUV mask blank) for a reflective mask (an EUV mask) used in EUV lithography utilizing EUV light as exposure light. A wavelength of EUV light used in EUV lithography utilizing EUV light as exposure light is 13 to 14 nm, normally about 13.5 nm.

For EUV light exposure, the substrate preferably has low thermal expansion property. For example, the substrate is composed of a material having a coefficient of thermal expansion preferably within ±2×10⁻⁸/°C, more preferably within ±5×10⁻⁹/°C. As such a material, for example, a titania-doped quartz glass (SiO₂-TiO₂-based glass) can be exemplified. Further, a substrate having a sufficiently flatted surface is preferably used. The main surface of the substrate has a surface roughness, as an RMS value, of preferably not more than 0.5 nm, more preferably not more than 0.2 nm. Such a surface roughness can be obtained by polishing the substrate or other method. As dimensions of the substrate, the main surface of the substrate preferably has a 152 mm-square, and a 6.35 mm-thick. A substrate having the dimensions is so-called a 6025 substrate (a substrate having dimensions of the main surface of a 6 inches-square and 0.25 inches-thick).

The multilayer reflection film may be formed in contact with one main surface of the substrate, and an underlayer film may be formed between the substrate and the multilayer reflection film. The multilayer reflection film is a film that reflects EUV light, which is exposure light, in the reflective mask. The multilayer reflection film has a periodically laminated structure in which high refractive index layers having a comparatively high refractive index with respect to exposure light and low refractive index layers having a comparatively low refractive index with respect to exposure light are alternately laminated.

The high refractive index layer is preferably a layer containing silicon (Si). The high refractive index layer may contain at least one additive element selected from the group consisting of oxygen (O), nitrogen (N), carbon (C), boron (B) and hydrogen (H). Further, the high refractive index layer may be configured by a multilayer including a layer containing the additive element and a layer not containing the additive element. The high refractive index layer has a thickness of preferably not less than 3.5 nm, more preferably not less than 4 nm, and preferably not more than 4.9 nm, more preferably not more than 4.4 nm. The low refractive index layer is preferably a layer containing molybdenum (Mo). The low refractive index layer may contain at least one additive element selected from the group consisting of oxygen (O), nitrogen (N), carbon (C), boron (B) and hydrogen (H). Further, the low refractive index layer may be configured by a multilayer including a layer containing the additive element and a layer not containing the additive element. The low refractive index layer has a thickness of preferably not less than 2.1 nm, more preferably not less than 2.6 nm, and preferably not more than 3.5 nm, more preferably not more than 3 nm. The multilayer reflection film has a thickness of preferably not less than 200 nm, more preferably not less than 270 nm, and preferably not more than 400 nm, more preferably not more than 290 nm.

Examples of methods for forming the multilayer reflection film include a sputtering method in which, to perform sputtering, power is supplied to a target, and plasma of an atmospheric gas is formed (an atmospheric gas is ionized) by the supplied power, and an ion beam sputtering method in which a target is irradiated with ion beam. The sputtering methods include a DC sputtering method in which a DC voltage is applied to a target, and an RF sputtering method in which a high frequency voltage is applied to a target. The sputtering method is a film forming method that utilizes sputtering phenomenon by gas ions generated by applying a voltage to a target with feeding a sputtering gas into a chamber to ionize the gas. Particularly, a magnetron sputtering method has an advantage in productivity. The power may be applied to the target by a DC system or an RF system. The DC system includes also a pulse sputtering in which a negative bias applied to the target is inverted for a short time to prevent charge-up of the target.

The multilayer reflection film may be formed by, for example, a sputtering method using a sputtering apparatus to which a plurality of targets can be attached. In particular, the multilayer reflection film may be formed with using, as targets, targets appropriately selected from the group consisting of a molybdenum (Mo) target for forming a molybdenum (Mo)-containing layer, a silicon (Si) target for forming a silicon (Si)-containing layer, and other targets, and with using, as a sputtering gas, a rare gas such as helium (He) gas, argon (Ar) gas, krypton (Kr) gas and xenon (Xe) gas.

Further, in the case that the sputtering is reactive sputtering using a sputtering gas, for example, a nitrogen-containing gas such as nitrogen (N₂) gas to form a nitrogen (N)-containing film, an oxygen-containing gas such as oxygen (O₂) gas to form an oxygen (O)-containing film, a nitrogen oxide gas such as nitrous oxide (N₂O) gas, nitrogen monoxide (NO) gas and nitrogen dioxide (NO₂) gas to form a nitrogen (N) and oxygen (O)-containing film, a carbon oxide gas such as carbon monoxide (CO) gas and carbon dioxide (CO₂) gas to form a carbon (C) and oxygen (O)-containing film, a hydrogen-containing gas such as hydrogen (H₂) gas to form a hydrogen (H)-containing film, or a hydrocarbon gas such as methane (CH₄) gas to form a carbon (C) and hydrogen (H)-containing film may be used with the rare gas. Moreover, a molybdenum (Mo) target added with boron (B) (a molybdenum boride (MoB) target), a silicon (Si) target added with boron (B) (a silicon boride (SiB) target) may be used to form a boron (B)-containing layer.

The protection film is a film that protects the multilayer reflection film in the reflective mask blank. The protection film contains ruthenium (Ru) and niobium (Nb). Further, the protection film has a structure that includes a portion having a low ruthenium (Ru) content in the thickness direction compared with both ruthenium (Ru) contents at the side close to the multilayer reflection film (in particular, at the interface or interface portion close to the multilayer reflection film), and at the side remotest from the multilayer reflection film (in particular, at the interface or interface portion remotest from the multilayer reflection film). Thus, the protection film has a structure in which the composition is varied in the thickness direction, and a portion (mid-portion) having a low ruthenium (Ru) content other than the side close to the multilayer reflection film and the side remotest from the multilayer reflection film. The protection film has a structure in which a ruthenium (Ru) content stepwise and/or continuously varies along the thickness direction. The protection film may contain an additive element such as oxygen (O), nitrogen (N), carbon (C) and other elements. However, the protection film is preferably free of oxygen, more preferably free of the additive element at the side close to the multilayer reflection film and at the side remotest from the multilayer reflection film. The protection film is formed on the multilayer reflection film. The protection film may be formed on the multilayer reflection film via another film that is intervened between the protection film and the multilayer reflection film. Normally, the protection film is formed in contact with the multilayer reflection film.

When the ruthenium (Ru) content at the side remotest from the multilayer reflection film is higher than the ruthenium (Ru) content of the inner side (the substrate side) from the side remotest from the multilayer reflection film, high resistances to dry etching using a gas containing chlorine and being free of oxygen, and SPM cleaning are exerted. When the ruthenium (Ru) content at the side remotest from the multilayer reflection film is higher than the ruthenium (Ru) content of the inner side (the substrate side) from the side remotest from the multilayer reflection film, formation of niobium (Nb) oxide at the surface portion of the protection film that is caused by cleaning, heat treatment, natural oxidation, or others is suppressed after forming the protection film. Accordingly, damages in the protection film are controlled in dry etching using a gas containing chlorine and being free of oxygen that is applied in patterning an absorber film, and SPM cleaning. The ruthenium (Ru) content of the protection film at the side remotest from the multilayer reflection film is preferably not less than 90 at%. More preferably, in the protection film, the side remotest form the multilayer reflection film does not contain substantively any other elements except for ruthenium (Ru), particularly consists of ruthenium (Ru). The SPM cleaning is cleaning with a mixed solution of sulfuric acid and hydrogen peroxide (sulfuric acid-hydrogen peroxide mixture), and the sulfuric acid-hydrogen peroxide mixture is generally a mixed solution of sulfuric acid and hydrogen peroxide in a volume ratio (sulfuric acid/ hydrogen peroxide) of 1/0.25 to 1/1.

When the ruthenium (Ru) content of the inner side (the substrate side) apart from the side remotest from the multilayer reflection film is low, high resistance to dry etching using a gas containing chlorine and oxygen is exerted. If the portion (mid-portion) other than the side close to the multilayer reflection film and the side remotest from the multilayer reflection film has a ruthenium (Ru) content too high, sufficient resistance to dry etching using a gas containing chlorine and oxygen may not be exerted. Therefore, in the protection film, the portion having a low ruthenium (Ru) content compared with both of the side close to the multilayer reflection film and the side remotest from the multilayer reflection film has a ruthenium (Ru) content of preferably less than 90 at%, more preferably not more than 85 at%.

On the other hand, if the portion (mid-portion) other than the side close to the multilayer reflection film and the side remotest from the multilayer reflection film has a ruthenium (Ru) content too low, sufficient resistance to SPM cleaning in manufacturing the reflective mask or use of the reflective mask may not be exerted, or formation of niobium (Nb) oxide in the mid-portion of the protection film that is caused by cleaning, heat treatment, natural oxidation, or others may be accelerated after forming the protection film. The formation of niobium (Nb) oxide changes an optical constant with respect to EUV light and causes decrease in reflectance. Therefore, in the protection film, the portion having a low ruthenium (Ru) content compared with both of the side close to the multilayer reflection film and the side remotest from the multilayer reflection film has a ruthenium (Ru) content of preferably not less than 50 at%. In the protection film, the portion having a low ruthenium (Ru) content compared with both of the side close to the multilayer reflection film and the side remotest from the multilayer reflection film preferably contains niobium (Nb). In the protection film, the portion having a low ruthenium (Ru) content compared with both of the side close to the multilayer reflection film and the side remotest from the multilayer reflection film may contain ruthenium (Ru) when the portion contains niobium (Nb).

When the ruthenium (Ru) content at the side close to the multilayer reflection film is higher than the ruthenium (Ru) content of the inner side (the side remote from the substrate) apart from the side close to the multilayer reflection film, high resistance to SPM cleaning is exerted. When the ruthenium (Ru) content is high, the niobium (Nb) oxide is hard to be formed. Thus, even when damage to the protection film has been approached to the side close to the multilayer reflection film by repeatedly using the reflective mask, the resistance of the protection film to SPM cleaning can be remained by the side close to the multilayer reflection film having a high ruthenium (Ru) content. The ruthenium (Ru) content of the protection film at the side close to the multilayer reflection film is preferably not less than 95 at%. More preferably, the side close to the multilayer reflection film does not contain substantively any other elements except for ruthenium (Ru), particularly consists of ruthenium (Ru).

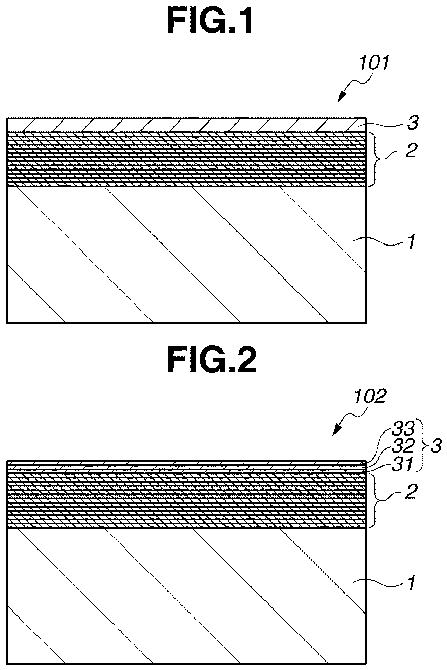

FIG. 1 is a cross-sectional view illustrating an example of first embodiment of a reflective mask blank of the invention. This reflective mask blank 101 includes a substrate 1, a multilayer reflection film 2 that is formed in contact with the substrate 1, and a protection film 3 that is formed in contact with the multilayer reflection film 2. In this case, the protection film 3 has a structure in which its composition varies along the thickness direction.

From the viewpoint of reducing damage by etching or cleaning in the whole of the protection film, the protection film has an average ruthenium (Ru) content in the whole of the protection film of preferably not less than 50 at%, more preferably not less than 60 at%, even more preferably not less than 65 at%, and preferably not more than 95 at%, more preferably not more than 90 at%.

If the protection film is too thin, sufficient resistance to etching in manufacturing the reflective mask, or sufficient resistance to SPM cleaning in manufacturing the reflective mask or use of the reflective mask is not exerted. If the protection film is too thick, the reflectance with respect to EUV light is significantly reduced. Therefore, the protection film has a thickness of preferably not less than 2 nm, more preferably not less than 3 nm, and preferably not more than 5 nm, more preferably not more than 4 nm.

The protection film may consist of a first layer, a second layer and a third layer in this order from the multilayer reflection film side. In this case, a structure that includes a second layer having a low ruthenium (Ru) content compared with both ruthenium (Ru) contents of a first layer at the side close to the multilayer reflection film and a third layer at the side remotest from the multilayer reflection film can be configured. Each of the first, second and third layers may have a structure in which a ruthenium (Ru) content stepwise and/or continuously varies along the thickness direction, and/or a structure in which a niobium (Nb) content stepwise and/or continuously varies along the thickness direction. Each of the first, second and third layers may contain an additive element such as oxygen (O), nitrogen (N), carbon (C) and other elements. However, the first and third layers are preferably free of oxygen, more preferably free of the additive element.

The third layer is preferably a layer containing ruthenium (Ru). When the ruthenium (Ru) content of the third layer is higher than the ruthenium (Ru) content of the second layer, high resistances to dry etching using a gas containing chlorine and being free of oxygen, and SPM cleaning are exerted. When the ruthenium (Ru) content of the third layer is higher than the ruthenium (Ru) content of the second layer, formation of niobium (Nb) oxide at the surface portion of the protection film that is caused by cleaning, heat treatment, natural oxidation, or others is suppressed after forming the protection film. Accordingly, damages in the protection film are controlled in dry etching using a gas containing chlorine and being free of oxygen that is applied in patterning an absorber film, and SPM cleaning. The ruthenium (Ru) content of the third layer in the protection film is preferably not less than 90 at%. More preferably, the third layer in the protection layer does not contain substantively any other elements except for ruthenium (Ru), particularly consists of ruthenium (Ru).

The third layer has a thickness of preferably not less than 0.2 nm, more preferably not less than 0.5 nm, and preferably not more than 3.5 nm, more preferably not more than 1.5 nm.

The second layer is preferably a layer containing niobium (Nb). When the ruthenium (Ru) content of the second layer is low, high resistance to dry etching using a gas containing chlorine and oxygen is exerted. If the second layer has a ruthenium (Ru) content too high, sufficient resistance to dry etching using a gas containing chlorine and oxygen may not be exerted. Therefore, the second layer has a ruthenium (Ru) content of preferably less than 90 at%, more preferably not more than 85 at%.

On the other hand, if the second layer has a ruthenium (Ru) content too low, sufficient resistance to SPM cleaning in manufacturing the reflective mask or use of the reflective mask may not be exerted, or formation of niobium (Nb) oxide in the second layer that is caused by cleaning, heat treatment, natural oxidation, or others may be accelerated after forming the protection film. The formation of niobium (Nb) oxide changes an optical constant with respect to EUV light and causes decrease in reflectance. Therefore, the second layer has a ruthenium (Ru) content of preferably not less than 50 at%. The second layer preferably contains niobium (Nb), and the second may contain ruthenium (Ru) when the portion contains niobium (Nb).

The second layer has a thickness of preferably not less than 0.3 nm, more preferably not less than 1 nm, and preferably not more than 4.5 nm, more preferably not more than 3.5 nm.

The first layer preferably is a layer containing ruthenium (Ru). When the ruthenium (Ru) content of the first layer is higher than the ruthenium (Ru) content of the second layer, high resistance to SPM cleaning is exerted. When the ruthenium (Ru) content is high, the niobium (Nb) oxide is hard to be formed. Thus, even when damage to the protection film has been approached to the first layer by repeatedly using the reflective mask, the resistance of the protection film to SPM cleaning can be remained by the first layer having a high ruthenium (Ru) content. The ruthenium (Ru) content of the first layer in the protection film is preferably not less than 95 at%. More preferably, the first layer in the protection layer does not contain substantively any other elements except for ruthenium (Ru), particularly consists of ruthenium (Ru).

The first has a thickness of preferably not less than 0.2 nm, more preferably not less than 0.3 nm, and preferably not more than 4.5 nm, more preferably not more than 3 nm, even more preferably not more than 1.5 nm.

FIG. 2 is a cross-sectional view illustrating an example of second embodiment of a reflective mask blank of the invention. This reflective mask blank 102 includes a substrate 1, a multilayer reflection film 2 that is formed in contact with the substrate 1, and a protection film 3 that is formed in contact with the multilayer reflection film 2. In this case, the protection film 3 has a three-layer structure consisting of, from the multilayer reflection film 2 side, a first layer 31 that is formed in contact with the multilayer reflection film 2, a second layer 32 that is formed in contact with the first layer 31, and a third layer 33 that is formed in contact with the second layer 32.

The composition and thickness of the protection film (the composition and thickness of each of the first layer, second layer, and third layer) are determined in accordance with treatment conditions for etching in manufacturing the reflective mask or for cleaning in manufacturing the reflective mask or use of the reflective mask, or environment in which the reflective mask is used.

The protection film (each layer constituting the protection film) can be formed by, for example, a sputtering method. As a target, a ruthenium (Ru) target or a ruthenium (Ru) alloy target may be used to form a film or a layer containing ruthenium (Ru), and a niobium (Nb) target or a niobium (Nb) alloy target may be used to form a film or a layer containing niobium (Nb). In particular, a target is appropriately selected and used from a ruthenium (Ru) target, a niobium (Nb) target, an alloy target of ruthenium (Ru) and niobium (Nb). The protection film (each layer constituting the protection film) may be formed by sputtering using, as a puttering gas, a rare gas such as helium (He) gas, neon (Ne) gas, argon (Ar) gas, krypton (Kr) gas and xenon (Xe) gas, or by reactive sputtering using a reactive gas such as an oxygen-containing gas, a nitrogen-containing gas and a carbon-containing gas with a rare gas. In particular, examples of the reactive gases include oxygen (O₂) gas, nitrogen (N₂) gas, a nitrogen oxide gas such as nitrous oxide (N₂O) gas, nitric oxide (NO) gas and nitrogen dioxide (NO₂) gas, and a carbon oxide gas such as carbon monoxide (CO) gas and carbon dioxide (CO₂) gas.

The composition of the protection film (each layer constituting the protection film) can be controlled by an amount of an electric power (a ratio of electric powers) applied to the target(s). Further, the thickness of the protection film (each layer constituting the protection film) can be controlled by an amount of the power applied to the target, a time period for applying the power to the target.

On the protection film, generally, an absorber film is further formed as a pattern forming film to obtain a reflective mask blank (an EUV mask blank) including a substrate, a multilayer reflection film, a protection film, and an absorber film, and a reflective mask (an EUV mask) is manufactured by patterning the absorber film.

The reflective mask blank of the invention may further include an absorber film that absorbs exposure light on the protection film. In particular, as such a reflective mask blank, examples include a reflective mask blank including a substrate, a multilayer reflection film that is formed on one main surface of the substrate and reflects exposure light, a protection film formed on the multilayer reflection film, and an absorber film that is formed on the protection film and absorbs the exposure light. A reflective mask including the substrate, the multilayer reflection film that is formed on one main surface of the substrate and reflects exposure light, the protection film formed on the multilayer reflection film, and a pattern of the absorber film (an absorber pattern) formed on the protection film and absorbs the exposure light can be manufactured from the reflective mask blank including the multilayer reflection film, the protection film and the absorber film. The absorber film is a film that absorbs exposure light, in particular, EUV light, and reduces reflectance. The absorber film is preferably formed in contact with the protection film.

The absorber film is formed on the multilayer reflection film, and absorbs EUV light, which is exposure light, and is a film to reduce a reflectance of the exposure light. In the reflective mask, a transfer pattern is formed by a difference in reflectance between a portion where an absorber film is formed and a portion where an absorber film is not formed.

A material for the absorber film is not limited as long as the material can absorb EUV light and can be processed to a pattern. Examples of the materials of the absorber film include, for example, a material containing tantalum (Ta). In particular, examples of the materials containing tantalum (Ta) include Ta simple substance, and a tantalum (Ta) compound such as TaO, TaN, TaON, TaC, TaCN, TaCO, TaCON, TaB, TaOB, TaNB, TaONB, TaCB, TaCNB, TaCOB and TaCONB.

As a material for the absorber film, a material containing tantalum (Ta) and nitrogen (N), particularly a material consisting of tantalum (Ta) and nitrogen (N) is preferable. In the dry etching using a gas containing chlorine and being free of oxygen, since etching selectivity to a protection film composed of a material containing ruthenium (Ru), and also etching selectivity to a hard mask film described later, particularly a hard mask film composed of a material containing chromium are high, the material imparts good processability in pattern forming of the absorber film. In the material containing tantalum (Ta) and nitrogen (N) of the absorber film, the material has a tantalum (Ta) content of preferably not less than 30 at%, more preferably not less than 40 at%, and preferably not more than 90 at%, more preferably not more than 85 at%. The material has a nitrogen (N) content of preferably not less than 10 at%, more preferably not less than 15 at%, and preferably not more than 60 at%, more preferably not more than 50 at%. The absorber film has a thickness of preferably not less than 20 nm, more preferably not less than 30 nm, and preferably not more than 100 nm, more preferably not more than 80 nm.

The absorber film can be formed by a sputtering method, and the sputtering is preferably magnetron sputtering. In particular, the absorber film may be formed by sputtering using a target such as a tantalum (Ta) target, a tantalum (Ta) compound target (a target containing tantalum (Ta), and at least one element selected from the group consisting of oxygen (O), nitrogen (N), carbon (C), boron (B), and other elements), and using, as a sputtering gas, a rare gas such as helium (He) gas, neon (Ne) gas, argon (Ar) gas, krypton (Kr) gas and xenon (Xe) gas, or by reactive sputtering using, as the sputtering gas, a reactive gas such as an oxygen-containing gas, a nitrogen-containing gas and a carbon-containing gas with the rare gas. In particular, examples of the reactive gases include oxygen (O₂) gas, nitrogen (N₂) gas, a nitrogen oxide gas such as nitrous oxide (N₂O) gas, nitric oxide (NO) gas and nitrogen dioxide (NO₂) gas, and a carbon oxide gas such as carbon monoxide (CO) gas and carbon dioxide (CO₂) gas. Furthermore, a film containing boron (B) is formed, a tantalum boride (TaB) target which is a tantalum (Ta) target added with boron (B) may be used.

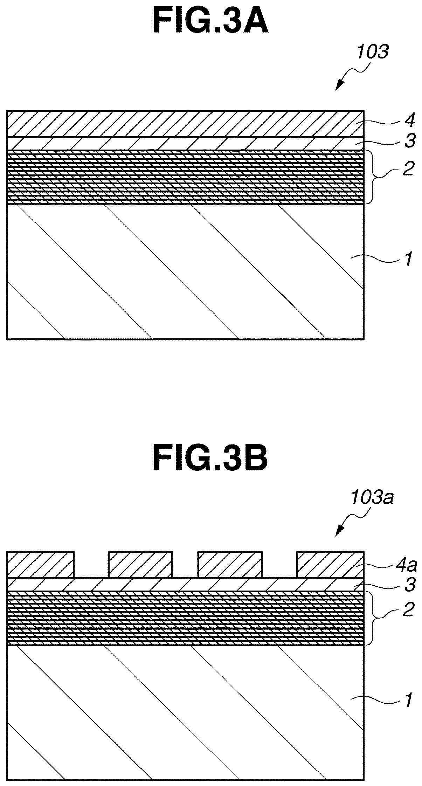

FIGS. 3A and 3B are cross-sectional views illustrating examples of third embodiment of a reflective mask blank and a reflective mask of the invention. This reflective mask blank 103 includes a substrate 1, a multilayer reflection film 2 that is formed in contact with the substrate 1, a protection film 3 that is formed in contact with the multilayer reflection film 2, and an absorber film 4 that is formed in contact with the protection film 3. On the other hand, this reflective mask 103a includes a substrate 1, a multilayer reflection film 2 that is formed in contact with the substrate 1, a protection film 3 that is formed in contact with the multilayer reflection film 2, and a pattern of an absorber film (an absorber pattern) 4a that is formed in contact with the protection film 3. In these cases, the protection film 3 has a structure in which its composition varies along the thickness direction.

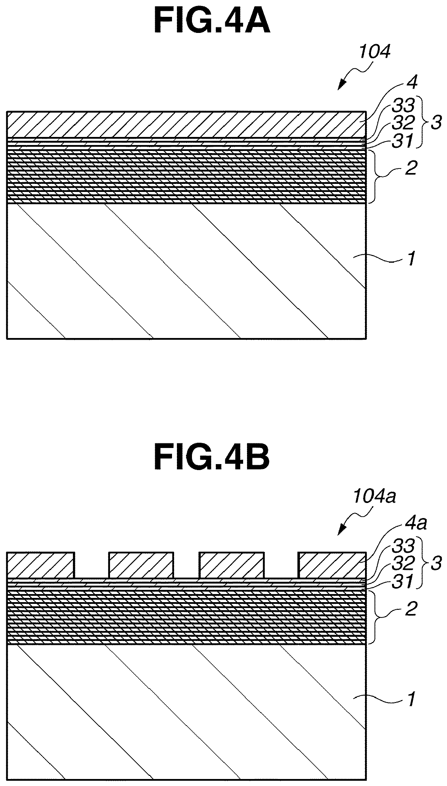

FIGS. 4A and 4B are cross-sectional views illustrating examples of fourth embodiment of a reflective mask blank and a reflective mask of the invention. This reflective mask blank 104 includes a substrate 1, a multilayer reflection film 2 that is formed in contact with the substrate 1, a protection film 3 that is formed in contact with the multilayer reflection film 2, and an absorber film 4 that is formed in contact with the protection film 3. On the other hand, this reflective mask 104a includes a substrate 1, a multilayer reflection film 2 that is formed in contact with the substrate 1, a protection film 3 that is formed in contact with the multilayer reflection film 2, and a pattern of an absorber film (an absorber pattern) 4a that is formed in contact with the protection film 3. In these cases, the protection film 3 has a three-layer structure consisting of, from the multilayer reflection film 2 side, a first layer 31 that is formed in contact with the multilayer reflection film 2, a second layer 32 that is formed in contact with the first layer 31, and a third layer 33 that is formed in contact with the second layer 32.

The reflective mask blank of the invention may further include a hard mask film that acts as an etching mask when the absorber film is dry-etched on the absorber film. In particular, as such a reflective mask blank, examples include a reflective mask blank including a substrate, a multilayer reflection film that is formed on one main surface of the substrate and reflects exposure light, a protection film formed on the multilayer reflection film, an absorber film that is formed on the protection film and absorbs the exposure light, and a hard mask film that is formed on the absorber film. A reflective mask including the substrate, the multilayer reflection film that is formed on one main surface of the substrate and reflects exposure light, the protection film formed on the multilayer reflection film, and a pattern of the absorber film (an absorber pattern) formed on the protection film and absorbs the exposure light can be manufactured from the reflective mask blank including the multilayer reflection film, the protection film, the absorber film and the hard mask film. A reflective mask further including a pattern of the hard mask film that is formed on the pattern of the absorber film (absorber pattern) can be obtained by remaining the pattern of the hard mask film as needed. The hard mask film is preferably formed in contact with the absorber film.

The hard mask film is a film that has different etching properties from the absorber film, and acts as an etching mask when the absorber film is dry-etched. After the pattern of the absorber film (absorber pattern) is formed, the hard mask film may be remained, for example, as a reflectance reducing film for reducing reflectance at a wavelength of light used in inspection such as pattern inspection, or may be removed to be absent on the reflective mask. Examples of the materials of the hard mask film include a material containing chromium (Cr). Particularly, a hard mask film composed of a material containing chromium (Cr) is preferable in the case that the absorber film is composed of a material containing tantalum (Ta) and free of chromium (Cr). When a layer that mainly assumes a function for reducing reflectance at a wavelength of light used in inspection such as pattern inspection (a reflectance reducing layer) is formed as a part of the absorber film, the hard mask film may be formed on the reflectance reducing layer of the absorber film. The hard mask has a thickness of normally about 5 to 20 nm, however, not particularly limited thereto.

The hard mask film can be formed by a sputtering method, and the sputtering is preferably magnetron sputtering. In particular, the hard mask film may be formed by sputtering using a target such as a chromium (Cr) target, a chromium (Cr) compound target (a target containing chromium (Cr), and at least one element selected from the group consisting of oxygen (O), nitrogen (N), carbon (C), and other elements), and using, as a sputtering gas, a rare gas such as helium (He) gas, neon (Ne) gas, argon (Ar) gas, krypton (Kr) gas and xenon (Xe) gas, or by reactive sputtering using, as the sputtering gas, a reactive gas such as an oxygen-containing gas, a nitrogen-containing gas and a carbon-containing gas with the rare gas. In particular, examples of the reactive gases include oxygen (O₂) gas, nitrogen (N₂) gas, a nitrogen oxide gas such as nitrous oxide (N₂O) gas, nitric oxide (NO) gas and nitrogen dioxide (NO₂) gas, and a carbon oxide gas such as carbon monoxide (CO) gas and carbon dioxide (CO₂) gas.

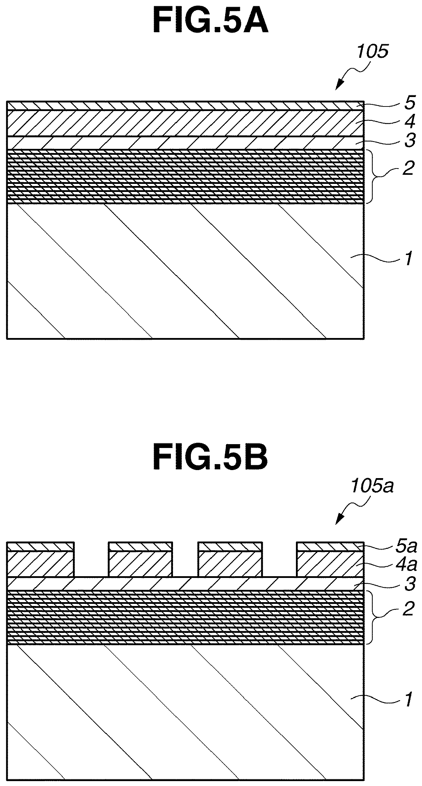

FIGS. 5A and 5B are cross-sectional views illustrating examples of fifth embodiment of a reflective mask blank and a reflective mask of the invention. This reflective mask blank 105 includes a substrate 1, a multilayer reflection film 2 that is formed in contact with the substrate 1, a protection film 3 that is formed in contact with the multilayer reflection film 2, an absorber film 4 that is formed in contact with the protection film 3, and a hard mask film 5 that is formed in contact with the absorber film 4. On the other hand, this reflective mask 105a includes a substrate 1, a multilayer reflection film 2 that is formed in contact with the substrate 1, a protection film 3 that is formed in contact with the multilayer reflection film 2, a pattern of an absorber film (an absorber pattern) 4a that is formed in contact with the protection film 3, and a pattern of a hard mask film 5a that is formed in contact with the pattern of the absorber film (absorber pattern) 4a. Furthermore, the hard mask film pattern 5a can be removed from this reflective mask 105a to provide the reflective mask 103a of the third embodiment illustrated in FIG. 3B. In these cases, the protection film 3 has a structure in which its composition varies along the thickness direction.

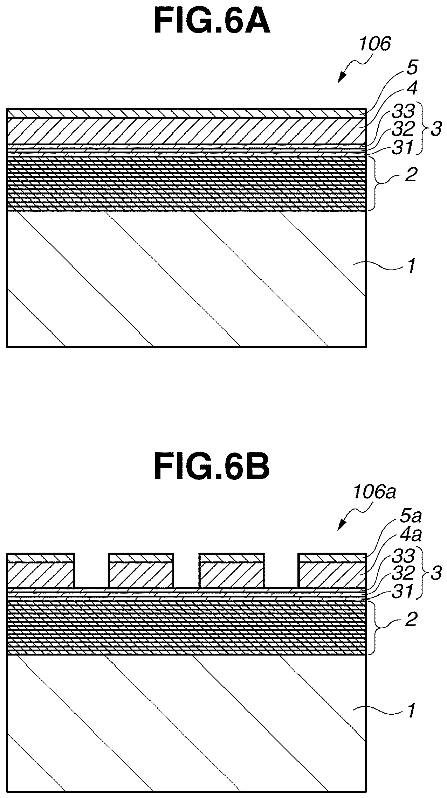

FIGS. 6A and 6B are cross-sectional views illustrating examples of sixth embodiment of a reflective mask blank and a reflective mask of the invention. This reflective mask blank 106 includes a substrate 1, a multilayer reflection film 2 that is formed in contact with the substrate 1, a protection film 3 that is formed in contact with the multilayer reflection film 2, an absorber film 4 formed in contact with the protection film 3, and a hard mask film 5 that is formed in contact with the absorber film 4. On the other hand, this reflective mask 106a includes a substrate 1, a multilayer reflection film 2 that is formed in contact with the substrate 1, a protection film 3 that is formed in contact with the multilayer reflection film 2, a pattern of an absorber film (an absorber pattern) 4a formed in contact with the protection film 3 and a pattern of a hard mask film 5a that is formed in contact with the pattern of the absorber film (absorber pattern) 4a. Furthermore, the hard mask film pattern 5a can be removed from this reflective mask 106a to provide the reflective mask 104a of the fourth embodiment illustrated in FIG. 4B. In these cases, the protection film 3 has a three-layer structure consisting of, from the multilayer reflection film 2 side, a first layer 31 that is formed in contact with the multilayer reflection film 2, a second layer 32 that is formed in contact with the first layer 31, and a third layer 33 that is formed in contact with the second layer 32.

The reflective mask blank may further include a conductive film used for electrostatic chucking to attach a reflective mask to an exposure apparatus may be formed on the other main surface (back-side surface) which is opposite across the substrate to the one main surface, preferably in contact with the other main surface.

The conductive film preferably has a sheet resistance of not more than 100 Ω/square, and a material for the conductive film is not limited. Examples of the materials of the conductive film include, for example, a material containing tantalum (Ta) or chromium (Cr). The material containing tantalum (Ta) or chromium (Cr) may contain oxygen (O), nitrogen (N), carbon (C), boron (B), or other elements. Examples of the materials containing tantalum (Ta) include, for example, Ta simple substance, and a tantalum (Ta) compound such as TaO, TaN, TaON, TaC, TaCO, TaCN, TaCON, TaB, TaOB, TaNB, TaONB, TaCB, TaCOB, TaCNB and TaCONB. Examples of the materials containing chromium (Cr) include, for example, Cr simple substance, and a chromium (Cr) compound such as CrO, CrN, CrON, CrC, CrCO, CrCN, CrCON, CrB, CrOB, CrNB, CrONB, CrCB, CrCOB, CrCNB and CrCONB.

The conductive film has a thickness of normally about 20 to 300 nm, however, not limited particularly thereto as long as the thickness is enough to act for use in electrostatic chucking. The conductive film is preferably formed so as to have a thickness at which film stresses between the conductive film, and the multilayer reflection film and a pattern of the absorber film (an absorber pattern) are balanced after obtaining the reflective mask, particularly, after forming the pattern of the absorber film (an absorber pattern). The conductive film may be formed before forming the multilayer reflection film, or after forming all the films on the substrate at the multilayer reflection film side. After forming a part of the films on the substrate at the multilayer reflection film side, the conductive film may be formed, and then the remainder of the films at the multilayer reflection film side may be formed on the substrate. The conductive film can be formed by, for example, a magnetron sputtering method.

The reflective mask blank of the invention may further include a resist film formed on the side remotest from the substrate. In the invention, the resist film is preferably an electron beam (EB) resist. Preferably, the resist film can be removed by SPM cleaning.

Next, a method for manufacturing a reflective mask from a reflective mask blank is described. In the case that a reflective mask including a substrate, a multilayer reflection film, a protection film, and a pattern of an absorber film (an absorber pattern) is manufactured from a reflective mask blank including a multilayer reflection film, a protection film and an absorber film, for example, first, a resist film pattern (a resist pattern) is formed on the absorber film of the reflective mask blank. In the invention, the resist film pattern (resist pattern) can be formed, by a conventional method including steps of exposure, development, washing and others, to a resist film which has been formed in a reflective mask blank, or to a resist film after forming a resist film onto a reflective mask blank. Next, a pattern of the absorber film (an absorber pattern) is formed by dry etching using a gas containing chlorine and being free of oxygen with using the pattern of the resist film (resist pattern) as an etching mask. Next, after forming the pattern of the absorber film (absorber pattern), the pattern of the resist film (resist pattern) is removed by SPM cleaning to obtain a reflective mask.

In the case that a reflective mask including a substrate, a multilayer reflection film, a protection film, a pattern of an absorber film (an absorber pattern), and a pattern of a hard mask film is manufactured from a reflective mask blank including a multilayer reflection film, a protection film, an absorber film and a hard mask film, for example, first, a resist film pattern (a resist pattern) is formed on the hard mask film of the reflective mask blank. Next, a pattern of the hard mask film is formed by dry etching using a gas containing chlorine and oxygen with using the pattern of the resist film (resist pattern) as an etching mask. Next, a pattern of the absorber film (an absorber pattern) is formed by dry etching using a gas containing chlorine and being free of oxygen with using the pattern of the hard mask film as an etching mask. Next, after forming the pattern of the absorber film (absorber pattern), the resist pattern is removed by SPM cleaning to obtain a reflective mask in which the pattern of the hard mask film is remained. Further, after removing the pattern of the resist film (resist pattern), the pattern of the hard mask film is removed by dry etching using a gas containing chlorine and oxygen to obtain a reflective mask not including the pattern of the hard mask film.

Since the side remotest from the multilayer reflection film or the third layer is formed so as to have a high ruthenium (Ru) content, the protection film of the invention exerts high resistance to dry etching using a gas containing chlorine and being free of oxygen for forming a pattern of an absorber film (an absorber pattern), and high resistance to subsequent SPM cleaning for removing a pattern of a resist film (a resist pattern).

Since the inner side in the thickness direction or the second layer is formed so as to have a low ruthenium (Ru) content compared with both the side close to the multilayer reflection film or the first layer, and the side remotest from the multilayer reflection film or the third layer, the protection film of the invention exerts high resistance to dry etching using a gas containing chlorine and oxygen for forming a pattern of a hard mask film.

Since the side close to the multilayer reflection film or the first layer is formed so as to have a high ruthenium (Ru) content, resistance to SPM cleaning of the protection film of the invention can be remained even when damage to the protection film has been approached to the side close to the multilayer reflection film by repeatedly using the reflective mask.

As described above, the protection film of the reflective mask blank of the invention has high resistances to dry etching using a gas containing chlorine and being free of oxygen and dry etching using a gas containing chlorine and oxygen that are applied in manufacturing a reflective mask from a reflective mask blank, and has high resistance to SPM cleaning that is applied in manufacturing a reflective mask from a reflective mask blank, further in use of a reflective mask.

### EXAMPLES

Examples of the invention are given below by way of illustration and not by way of limitation.

### Example 1

A multilayer reflection film was formed on a low thermal expansion substrate (SiO₂-TiO₂-based glass substrate) having dimensions of 152 mm-square and 6.35 mm-thick while rotating the substrate by DC pulse magnetron sputtering with using a molybdenum (Mo) target and a silicon (Si) target that were placed so as to face to the main surface of the substrate. Each of the targets was attached to a sputtering apparatus that is capable of attaching two targets and discharging the targets one by one, or both targets at the same time, and the substrate was placed into the sputtering apparatus.

First, a silicon (Si) layer having a thickness of 4.2 nm was formed by applying an electric power to the silicon (Si) target while feeding argon (Ar) gas (flow rate: 12 SCCM) into a chamber, then, the application of electric power to the silicon target was terminated. Next, a molybdenum (Mo) layer having a thickness of 2.8 nm was formed by applying an electric power to the molybdenum target while feeding argon gas (flow rate: 15 SCCM) into the chamber, then, the application of electric power to the molybdenum target was terminated. The one cycle which is a set of the formations of the silicon (Si) layer and the molybdenum (Mo) layer was repeated for 40 cycles, and after forming the molybdenum (Mo) layer at 40th cycle, finally, a silicon (Si) layer having a thickness of 4.2 nm was formed by the above-described method. Accordingly, the multilayer reflection film was formed.

Next, a protection film that is in contact with the multilayer reflection film was formed on the multilayer reflection film while rotating the substrate by DC pulse magnetron sputtering with using a ruthenium (Ru) target and a niobium (Nb) target that were placed so as to face to the main surface of the substrate. Each of the targets was attached to another sputtering apparatus that is capable of attaching two targets and discharging the targets one by one, or both targets at the same time, and the substrate having the formed multilayer reflection film was placed into the sputtering apparatus.

First, a simple ruthenium (Ru) layer (a Ru layer) having a thickness of 1.5 nm, as a first layer of the protection film that is in contact with the multilayer reflection film, was formed by applying an electric power to the ruthenium (Ru) target while feeding argon (Ar) gas (flow rate: 10 SCCM) into a chamber, then, the application of electric power to the ruthenium (Ru) target was terminated.

Next, a simple niobium (Nb) layer (a Nb layer) having a thickness of 1 nm, as a second layer of the protection film that is in contact with the first layer, was formed by applying an electric power to the niobium (Nb) target while feeding argon (Ar) gas (flow rate: 10 SCCM) into the chamber, then, the application of electric power to the niobium (Nb) target was terminated.

Next, a simple ruthenium (Ru) layer (a Ru layer) having a thickness of 0.5 nm, as a third layer of the protection film that is in contact with the second layer, was formed by applying an electric power to the ruthenium (Ru) target while feeding argon (Ar) gas (flow rate: 10 SCCM) into the chamber, then, the application of electric power to the ruthenium (Ru) target was terminated.

By these operations, a protection film that has a structure in which the composition is varied in the thickness direction and a thickness of 3 nm was formed to obtain a reflective mask blank. The protection film had an average ruthenium (Ru) content in the whole of the protection film of 73 at% that was calculated based on the contents and thicknesses of the first layer, the second layer and the third layer of the protection film. The thickness was confirmed from a cross-sectional image by a transmission electron microscope image utilizing energy dispersive X-ray spectroscopy (TEM-EDX).

Next, resistance of the obtained protection film was evaluated. To the protection film, dry etching treatment was performed for 128 seconds with using a gas containing chlorine and being free of oxygen (Ch flow rate: 150 SCCM, He flow rate: 10 SCCM), and next, dry etching treatment was performed for 45 seconds with using a gas containing chlorine and oxygen (Cl₂ flow rate: 150 SCCM, O₂ flow rate: 30 SCCM, He flow rate: 10 SCCM), and then SPM cleaning treatment (H₂SO₄:H₂O₂=3:1, 6 minutes) was performed. A thickness of the protection film after the treatments was measured, and it was confirmed that the thickness was reduced by 0.6 nm compared with the thickness of the protection film when forming.

### Example 2

A reflective mask blank was obtained in the same manner as in Example 1 except for the second layer. A layer consisting of ruthenium (Ru) and niobium (Nb) (a RuNb layer) having a thickness of 1 nm, as the second layer, was formed by applying electric powers to the ruthenium (Ru) target and the niobium (Nb) target while feeding argon (Ar) gas (flow rate: 10 SCCM) into the chamber.

The obtained second layer of the protection film had a ruthenium (Ru) content of 50 at%. The protection film had an average ruthenium (Ru) content in the whole of the protection film of 85 at% that was calculated based on the contents and thicknesses of the first layer, the second layer and the third layer of the protection film. Next, resistance of the obtained protection film was evaluated in the same manner as in Example 1. A thickness of the protection film after the treatments was measured, and it was confirmed that the thickness was reduced by 0.2 nm compared with the thickness of the protection film when forming.

### Example 3

A reflective mask blank was obtained in the same manner as in Example 2 except for the second layer. A layer consisting of ruthenium (Ru) and niobium (Nb) (a RuNb layer) having a thickness of 1 nm, as the second layer, was formed by setting an applied power lower than Example 2 to the niobium (Nb) target, and applying electric powers to the ruthenium (Ru) target and the niobium (Nb) target while feeding argon (Ar) gas (flow rate: 10 SCCM) into the chamber.

The obtained second layer of the protection film had a ruthenium (Ru) content of 85 at%. The protection film had an average ruthenium (Ru) content in the whole of the protection film of 95 at% that was calculated based on the contents and thicknesses of the first layer, the second layer and the third layer of the protection film. Next, resistance of the obtained protection film was evaluated in the same manner as in Example 1. A thickness of the protection film after the treatments was measured, and it was confirmed that the thickness was reduced by 1.6 nm compared with the thickness of the protection film when forming.

### Example 4

A reflective mask blank was obtained in the same manner as in Example 1 except for the first layer. A layer consisting of ruthenium (Ru) and niobium (Nb) (a RuNb layer) having a thickness of 1.5 nm, as the first layer, was formed by applying electric powers to the ruthenium (Ru) target and the niobium (Nb) target while feeding argon (Ar) gas (flow rate: 10 SCCM) into the chamber.

The obtained first layer of the protection film had a ruthenium (Ru) content of 95 at%. The protection film had an average ruthenium (Ru) content in the whole of the protection film of 70 at% that was calculated based on the contents and thicknesses of the first layer, the second layer and the third layer of the protection film. Next, resistance of the obtained protection film was evaluated in the same manner as in Example 1. A thickness of the protection film after the treatments was measured, and it was confirmed that the thickness was reduced by 1.6 nm compared with the thickness of the protection film when forming.

### Example 5

A reflective mask blank was obtained in the same manner as in Example 1 except for the third layer. A layer consisting of ruthenium (Ru) and niobium (Nb) (a RuNb layer) having a thickness of 0.5 nm, as the third layer, was formed by applying electric powers to the ruthenium (Ru) target and the niobium (Nb) target while feeding argon (Ar) gas (flow rate: 10 SCCM) into the chamber.

The obtained third layer of the protection film had a ruthenium (Ru) content of 90 at%. The protection film had an average ruthenium (Ru) content in the whole of the protection film of 71 at% that was calculated based on the contents and thicknesses of the first layer, the second layer and the third layer of the protection film. Next, resistance of the obtained protection film was evaluated in the same manner as in Example 1. A thickness of the protection film after the treatments was measured, and it was confirmed that the thickness was reduced by 0.7 nm compared with the thickness of the protection film when forming.

### Comparative Example 1

A reflective mask blank was obtained in the same manner as in Example 1 except for the protection film. A simple ruthenium (Ru) layer (a Ru layer) having a thickness of 3 nm, as the protection film having a single layer structure, was formed by applying an electric power to the ruthenium (Ru) target while feeding argon (Ar) gas (flow rate: 10 SCCM) into the chamber.

Next, resistance of the obtained protection film was evaluated in the same manner as in Example 1. A thickness of the protection film after the treatments was measured, and it was confirmed that the thickness was reduced by 2.8 nm compared with the thickness of the protection film when forming.

### Comparative Example 2

A reflective mask blank was obtained in the same manner as in Example 1 except for the protection film. When forming the protection film in the same manner as in Example 1, a simple ruthenium (Ru) layer (a Ru layer) having the same thickness of the first layer in Example 1 of 1.5 nm was formed. Next, a simple niobium (Nb) layer (a Nb layer) having a thickness of 1.5 nm was formed with changing the thickness of the second layer to form a protection film having a two-layer structure which is different from Example 1 without forming the third layer.

Next, resistance of the obtained protection film was evaluated in the same manner as in Example 1. A thickness of the protection film after the treatments was measured, and it was confirmed that protection film was disappeared.

### Comparative Example 3

A reflective mask blank was obtained in the same manner as in Example 1 except for the protection film. When forming the protection film in the same manner as in Example 1, a simple niobium (Nb) layer (a Nb layer) having a thickness of 2.5 nm was formed with changing the thickness of the second layer. Next, a simple ruthenium (Ru) layer (a Ru layer) having the same thickness of the third layer in Example 1 of 0.5 nm was formed to form a protection film having a two-layer structure which is different from Example 1 without forming the first layer.

Next, resistance of the obtained protection film was evaluated in the same manner as in Example 1. A thickness of the protection film after the treatments was measured, and it was confirmed that the thickness was reduced by 2.7 nm compared with the thickness of the protection film when forming.

## Claims

1. A reflective mask blank comprising a substrate, a multilayer reflection film that is formed on one main surface of the substrate and reflects exposure light, and a protection film that is formed on the multilayer reflection film wherein
the protection film comprises ruthenium (Ru) and niobium (Nb),
the protection film comprises a portion having a low ruthenium (Ru) content in the thickness direction compared with both ruthenium (Ru) contents at the side close to the multilayer reflection film and at the side remotest from the multilayer reflection film.

2. The reflective mask blank of claim 1 wherein
the portion having a low ruthenium (Ru) content in the protection film comprises niobium (Nb), and the portion having a low ruthenium (Ru) content in the protection film has a ruthenium (Ru) content of not more than 85 at%.

3. The reflective mask blank of claim 1 or 2 wherein
the ruthenium (Ru) content of the protection film at the side close to the multilayer reflection film is not less than 95 at%, and
the ruthenium (Ru) content of the protection film at the side remotest from the multilayer reflection film is not less than 90 at%.

4. The reflective mask blank of any one of claims 1 to 3 wherein
the protection film consists of a first layer, a second layer and a third layer in this order from the multilayer reflection film side,
the first layer comprises ruthenium (Ru) and does not comprise substantively any other elements except for ruthenium (Ru),
the second layer comprises niobium (Nb) and optionally comprises ruthenium (Ru), and
the third layer comprises ruthenium (Ru) and does not comprise substantively any other elements except for ruthenium (Ru).

5. The reflective mask blank of any one of claims 1 to 4 wherein the protection film has an average ruthenium (Ru) content in the whole of the protection film of not less than 50 at% and not more than 95 at%.

6. The reflective mask blank of any one of claims 1 to 5 comprising an absorber film that is formed on the protection film and absorbs the exposure light wherein
the absorber film comprises tantalum (Ta) and nitrogen (N).

7. The reflective mask blank of claim 6 further comprising a hard mask film that comprises chromium (Cr) on the absorber film.

8. A reflective mask comprising a substrate, a multilayer reflection film that is formed on one main surface of the substrate and reflects exposure light, a protection film that is formed on the multilayer reflection film, and a pattern of an absorber film that is formed on the protection film and absorbs the exposure light wherein
the protection film comprises ruthenium (Ru) and niobium (Nb),
the protection film comprises a portion having a low ruthenium (Ru) content in the thickness direction compared with both ruthenium (Ru) contents at the side close to the multilayer reflection film and at the side remotest from the multilayer reflection film.

9. The reflective mask of claim 8 wherein
the portion having a low ruthenium (Ru) content in the protection film comprises niobium (Nb), and the portion having a low ruthenium (Ru) content in the protection film has a ruthenium (Ru) content of not more than 85 at%.

10. The reflective mask of claim 8 or 9 wherein
the ruthenium (Ru) content of the protection film at the side close to the multilayer reflection film is not less than 95 at%, and
the ruthenium (Ru) content of the protection film at the side remotest from the multilayer reflection film is not less than 90 at%,

11. The reflective mask of any one of claims 8 to 10 wherein
the protection film consists of a first layer, a second layer and a third layer in this order from the multilayer reflection film side,
the first layer comprises ruthenium (Ru) and does not comprise substantively any other elements except for ruthenium (Ru),
the second layer comprises niobium (Nb) and optionally comprises ruthenium (Ru), and
the third layer comprises ruthenium (Ru) and does not comprise substantively any other elements except for ruthenium (Ru).

12. The reflective mask of any one of claims 8 to 11 wherein the protection film has an average ruthenium (Ru) content in the whole of the protection film of not less than 50 at% and not more than 95 at%.

13. A method for manufacturing a reflective mask comprising the steps of
forming a pattern of a resist film on the absorber film of the reflective mask blank of claim 6,
forming a pattern of the absorber film by dry etching using a gas containing chlorine and being free of oxygen with using the pattern of the resist film as an etching mask,
after the step of forming the pattern of the absorber film, removing the pattern of the resist film by SPM cleaning.

14. A method for manufacturing a reflective mask comprising the steps of
forming a pattern of a resist film on the hard mask film of the reflective mask blank of claim 7,
forming a pattern of the hard mask film by dry etching using a gas containing chlorine and oxygen with using the pattern of the resist film as an etching mask,
forming a pattern of the absorber film by dry etching using a gas containing chlorine and being free of oxygen with using the pattern of the hard mask film as an etching mask,
after the step of forming the pattern of the absorber film, removing the pattern of the resist film by SPM cleaning,
after the step of removing the pattern of the resist film, removing the pattern of the hard mask film by dry etching using a gas containing chlorine and oxygen.
